# EUROPÄISCHE PATENTSCHRIFT

(11) **EP 1 172 849 B1**
(45) Veröffentlichungstag und Bekanntmachung des Hinweises auf die Patenterteilung: **26.04.2006**
(21) Anmeldenummer: 01117039.6
(22) Anmeldetag: 12.07.2001
(51) Int. Cl.: H01L 21/822, H03H 3/02

(54) **Verfahren zur Erzeugung einer Mehrzahl von Chips mit Halbleiterbauelementen, die eine Schicht mit definierter elektrischer Polarisation aufweisen**
Method of manufacturing a plurality of chips comprising semiconductor devices which include a layer of defined electrical polarisation
Procédé de fabrication des plusieurs puces avec composants semiconducteurs ayant une couche à polarisation électrique définie

(30) Priorität: 13.07.2000 DE 10034085
(43) Veröffentlichungstag der Anmeldung: 16.01.2002
(73) Patentinhaber: Infineon Technologies AG, 81669 München (DE)
(72) Erfinder: Aigner, Robert, 81675 München (DE); Marksteiner, Stephan, 85579 Neubiberg (DE); Elbrecht, Lueder, 80805 München (DE)
(74) Vertreter: Ginzel, Christian

(56) Entgegenhaltungen:
- EP-A- 0 491 596
- PATENT ABSTRACTS OF JAPAN Bd. 018, Nr. 064 (P-1685), 2. Februar 1994 (1994-02-02) -& JP 05 281034 A (HORIBA LTD), 29. Oktober 1993 (1993-10-29)

## Beschreibung

Verfahren zur Erzeugung analog zueinander aufgebauter Chips, die jeweils ein erstes Halbleiterbauelement, das eine Schicht mit einer definierten elektrischen Polarisation aufweist, aufweisen.

Die Erfindung betrifft ein Verfahren zur Erzeugung analog zueinander aufgebauter Chips, die jeweils ein erstes Halbleiterbauelement, das eine Schicht mit einer definierten elektrischen Polarisation aufweist, aufweisen.

Ein solches erstes Halbleiterbauelement kann z. B. mechanische oder thermische Strahlung in elektrische Spannungsänderungen umwandeln oder umgekehrt. Dazu besteht die Schicht des ersten Halbleiterbauelements, die in der Regel zwischen zwei Elektroden angeordnet ist, aus einem piezoelektrischen bzw. pyroelektrischen Material.

Je höher der elektrische Polarisationsgrad der Schicht ist, um so ausgeprägter sind die akustischen Schwingungen oder die thermische Strahlung bei einer bestimmten Spannungsänderung. Nach dem Abscheiden des Materials zur Erzeugung der Schicht befindet sich die Schicht jedoch in einem Zustand geringer elektrischer Polarisation. Zur Erhöhung des Polarisationsgrades ist demnach ein Polungsvorgang erforderlich. Dazu wird bei einer Temperatur von über 150°C ein hohes elektrisches Feld in der Schicht appliziert, was aufgrund des sogenannten ferroelektrischen Effekts zu einer permanenten Polarisation des Materials der Schicht führt. Dies kann durch Erzeugung eines Spannungsabfalls in der Schicht erfolgen, indem an den Elektroden geeignete Spannungen angelegt werden.

Es ist üblich, zur effektiven und kostengünstigen Produktion von Chips mit Halbleiterbauelementen eine große Anzahl an analog zueinander aufgebauten Chips auf einem Wafer aus Halbleitermaterial herzustellen, und die Chips anschließend zu vereinzeln. Bei der Anwendung eines solchen Verfahrens auf die Herstellung von Chips, die jeweils ein oben beschriebenes erstes Halbleiterbauelement aufweisen, stellt sich das Problem, die Schichten der ersten Halbleiterbauelemente auf dem Wafer zu polen. Wegen der Vielzahl der Halbleiterbauelemente ist es weder effektiv noch kostengünstig, für den Polungsvorgang jedes erste Halbleiterbauelement einzeln zu kontaktieren.

Umfasst jeder Chip lediglich ein oben beschriebenes erstes Halbleiterbauelement, so lässt sich ein Verfahren zur Herstellung mehrerer analog zueinander aufgebauter Chips mittels eines Wafers leicht realisieren, da alle erste Halbleiterbauelemente der Chips auf dem Wafer zur Polung ihrer Schichten parallel geschaltet werden können.

Ein derartiges Verfähren geht zum Beispiel aus JP 05-281034 hervor.

Problematisch ist jedoch die Herstellung von Chips auf diesem Weg, wenn jeder Chip neben dem ersten Halbleiterbauelement auch mindestens ein zweites Halbleiterbauelement aufweist, das mit dem ersten Halbleiterbauelement verschaltet werden soll. In der Regel wird eine Parallelverschaltung der ersten Halbleiterbauelemente mit der gewünschten Verschaltung der Halbleiterbauelemente untereinander unvereinbar sein. Aus diesem Grund ist bislang noch kein Verfahren zur Erzeugung analog zueinander aufgebauter Chips, die jeweils ein erstes Halbleiterbauelement, das eine Schicht mit einer definierten elektrischen Polarisation aufweist, und ein zweites Halbleiterbauelement aufweisen unter Verwendung eines Wafers bekannt.

Der Erfindung liegt folglich die Aufgabe zugrunde, ein Verfahren zur Erzeugung analog zueinander aufgebauter Chips, die jeweils ein erstes Halbleiterbauelement, das eine Schicht mit einer definierten elektrischen Polarisation aufweist, und ein zweites Halbleiterbauelement aufweisen, unter Verwendung eines Wafers anzugeben, das effektiv und kostengünstig ist.

Die Aufgabe wird gelöst durch ein Verfahren zur Erzeugung analog zueinander aufgebauter Chips, die jeweils mindestens ein erstes Halbleiterbauelement, das eine Schicht mit einer definierten elektrischen Polarisation aufweist, aufweisen, bei dem die Chips auf einem Wafer erzeugt werden, wobei pro erstem Halbleiterbauelement die Schicht, die zunächst nicht ihre volle Polarisation aufweist, erzeugt wird. Pro Chip wird mindestens ein zweites Halbleiterbauelement erzeugt. Zur Erzeugung temporärer Leiterbahnen wird leitendes Material abgeschieden und derart strukturiert, daß jede Schicht der ersten Halbleiterbauelemente zwischen zwei der temporären Leiterbahnen geschaltet ist, und daß jede temporäre Leiterbahn mit Unterseiten oder Oberseiten der Schichten der ersten Halbleiterbauelemente mehrerer Chips auf dem Wafer verbunden ist. Die Schichten der ersten Halbleiterbauelemente werden gepolt, indem Spannungen an die temporären Leiterbahnen angelegt werden. Nach Polarisierung der Schichten der ersten Halbleiterbauelemente werden die temporären Leiterbahnen zumindest abschnittsweise entfernt. Zum Verschalten der ersten Halbleiterbauelemente mit den zweiten Halbleiterbauelementen werden Leiterbahnen einer Metallisierung der Chips erzeugt. Die Chips werden nach deren Fertigstellung vereinzelt.

Die Spannungen zum Polen der Schichten werden aufgrund der temporären Leiterbahnen an nur überschaubar wenigen Stellen auf dem Wafer angelegt, so daß das Verfahren effizient und kostengünstig ist.

Da die temporären Leiterbahnen zumindest abschnittsweise nach Polarisierung der Schichten wieder entfernt werden, können die Halbleiterbauelemente der Chips unabhängig von der Anordnung der temporären Leiterbahnen mit Hilfe der Leiterbahnen der Metallisierung miteinander verschaltet werden.

Das erste Halbleiterbauelement kann so erzeugt werden, daß es elektrische oder thermische Strahlung in elektrische Spannungsänderungen umwandelt oder umgekehrt. Dazu wird die Schicht des ersten Halbleiterbauelements aus einem piezo- oder pyroelektrischen Material erzeugt. Die Schicht des ersten Halbleiterbauelements kann beispielsweise aus PZT (Blei-Zirkonium-Titanat) erzeugt werden.

Beispielsweise ist das erste Halbleiterbauelement ein Bulk-Acoustic-Wave Resonator, ein Surface-Acoustic-Wave Resonator.

Pro erstem Halbleiterbauelement kann eine untere Elektrode, darüber die Schicht und darüber eine obere Elektrode erzeugt werden. Zur Erzeugung der temporären Leiterbahnen kann leitendes Material abgeschieden und derart strukturiert werden, daß jede temporäre Leiterbahn mit unteren oder oberen Elektroden der ersten Halbleiterbauelemente mehrerer Chips verbunden ist. In diesem Fall werden die oberen und die unteren Elektroden der ersten Halbleiterbauelemente zugleich als Elektroden zum Polen der Schichten der ersten Halbleiterbauelemente verwendet.

Alternativ können pro erstem Halbleiterbauelement zunächst eine temporäre obere Elektrode gleichzeitig oder vor den temporären Leiterbahnen erzeugt werden. Nach der Polarisierung der Schichten der ersten Halbleiterbauelemente können die temporären oberen Elektroden entfernt werden, und anschließend neue obere Elektroden erzeugt werden.

Bei einem besonders effizienten und kostengünstigen ersten Verfahren wird über den ersten Halbleiterbauelementen und den zweiten Halbleiterbauelementen eine isolierende Zwischenschicht abgeschieden. Anschließend werden Kontaktlöcher in der Zwischenschicht zu den ersten und den zweiten Halbleiterbauelementen erzeugt. Dabei werden mindestens für die unteren und für die oberen Elektroden der ersten Halbleiterbauelemente Kontaktlöcher erzeugt. Es wird eine Diffusionsbarrierenschicht aus leitendem Material mit einer solchen Dicke abgeschieden, daß sie die Kontaktlöcher nicht ausfüllt. Zur Erzeugung von Kontakten wird leitendes Material einer solchen Dicke über der Diffusionsbarrierenschicht abgeschieden, daß sie die Kontaktlöcher ausfüllt. Dieses leitende Material wird soweit rückgeätzt, daß die Diffusionsbarrierenschicht teilweise freigelegt wird. Durch Strukturierung der Diffusionsbarrierenschicht werden die temporären Leiterbahnen erzeugt. Die temporären Leiterbahnen bestehen also aus Teilen der Diffusionsbarrierenschicht. Nach Polarisierung der Schichten der ersten Halbleiterbauelemente wird zur Erzeugung der Leiterbahnen der Metallisierung leitendes Material abgeschieden und strukturiert, wobei außerhalb der Leiterbahnen der Metallisierung liegende Teile der Diffusionsbarrierenschicht entfernt werden.

Bei diesem ersten Verfahren wird die Diffusionsbarrierenschicht, die üblicherweise für Kontakte vorgesehen ist, zugleich für die Erzeugung der temporären Leiterbahnen verwendet.

Die Entfernung der außerhalb der Leiterbahnen der Metallisierung liegenden Teile der Diffusionsbarrierenschicht erfolgt vorzugsweise durch Überätzen des leitenden Materials bei der Erzeugung der Leiterbahnen der Metallisierung. Die temporären Leiterbahnen werden beim Strukturieren des leitenden Materials zur Erzeugung der Leiterbahnen der Metallisierung abschnittsweise entfernt. Für die abschnittsweise Entfernung der temporären Leiterbahnen ist also keine zusätzliche Maske oder zusätzlicher Ätzschritt erforderlich.

Die Zwischenschicht besteht beispielsweise aus SiO₂. Die Diffusionsbarrierenschicht besteht beispielsweise aus Titan, Titannitrid oder einer Kombination aus den beiden Materialien. Die Diffusionsbarrierenschicht ist vorzugsweise zwischen 20 und 50 nm dick. Das leitende Material zur Erzeugung der Kontakte enthält beispielsweise Wolfram. Das leitende Material zur Erzeugung der Leiterbahnen der Metallisierung enthält beispielsweise AlSiCu.

Gemäß eines zweiten Verfahrens können die temporären Leiterbahnen nach Polarisierung der Schichten der ersten Halbleiterbauelemente vollständig durch unmaskiertes selektives Ätzen entfernt werden. Die temporären Leiterbahnen werden also vor Abscheiden des leitenden Materials zur Erzeugung der Leiterbahnen der Metallisierung entfernt. Da die temporären Leiterbahnen vollständig entfernt werden, ist keine zusätzliche Maske für die Entfernung erforderlich.

Beispielsweise werden die temporären Leiterbahnen durch Sputtern von amorphem Silizium erzeugt. Um die temporären Leiterbahnen durch unmaskiertes selektives Trockenätzen vollständig zu entfernen, kann als Ätzmittel CF₄ verwendet werden. Mit einem solchen Ätzmittel kann selektiv zu SiO₂ geätzt werden.

Statt der vollständigen Entfernung der temporären Leiterbahnen können in einem dritten Verfahren die temporären Leiterbahnen nach Polarisierung der Schichten abschnittsweise derart entfernt werden, daß übrigbleibende Teile der temporären Leiterbahnen erste Teile der Leiterbahnen der Metallisierung bilden. Zur Erzeugung zweiter Teile der Leiterbahnen der Metallisierung wird leitendes Material abgeschieden und strukturiert.

Beispielsweise werden die temporären Leiterbahnen und die Leiterbahnen der Metallisierung aus demselben leitenden Material erzeugt. Zur Erzeugung der zweiten Teile der Leiterbahnen der Metallisierung wird das leitende Material derart strukturiert, daß die ersten Teile der Leiterbahnen der Metallisierung unter Teilen der zweiten Teile der Leiterbahnen der Metallisierung liegen. Bei der abschnittsweisen Entfernung der temporären Leiterbahnen wird eine erste Maske verwendet, die Stellen, an denen die Leiterbahnen der Metallisierung erzeugt werden sollen, bedeckt. Bei der Erzeugung der Leiterbahnen der Metallisierung wird eine zweite Maske verwendet, die dieselben Stellen bedeckt, die auch die erste Maske bedeckt hat. Die Leiterbahnen der Metallisierung sind in Bereichen, in denen auch Teile der temporären Leiterbahnen erzeugt wurden, besonders dick und weisen dort folglich einen besonders kleinen elektrischen Widerstand auf.

Alternativ werden die temporären Leiterbahnen und die Leiterbahnen der Metallisierung aus verschiedenen leitenden Materialien erzeugt. In diesem Fall kann zur Erzeugung der zweiten Teile der Leiterbahnen der Metallisierung das entsprechende leitende Material derart strukturiert werden, das die ersten Teile der Leiterbahnen der Metallisierung neben den zweiten Teilen der Leiterbahnen der Metallisierung liegen. Bei der Erzeugung der zweiten Teile der Leiterbahnen der Metallisierung wird eine Maske verwendet, die alle Bereiche, in denen die Leiterbahnen der Metallisierung erzeugt werden sollen bis auf Bereiche, in denen die ersten Teile der Leiterbahnen der Metallisierung erzeugt wurden, bedeckt, und es wird das Material der zweiten Teile selektiv zum Material der ersten Teile der Leiterbahnen der Metallisierung geätzt.

Die zweiten Halbleiterbauelemente können beispielsweise Transistoren oder Kondensatoren sein.

Alternativ sind die zweiten Halbleiterbauelemente ähnlich wie die ersten Halbleiterbauelemente aufgebaut. Dazu wird für die zweiten Halbleiterbauelemente jeweils eine Schicht mit einer definierten elektrischen Polarisation erzeugt. Die temporären Leiterbahnen werden so erzeugt, daß jede Schicht der zweiten Halbleiterbauelemente zwischen zwei der temporären Leiterbahnen geschaltet ist, und daß jede temporäre Leiterbahn mit Unterseiten oder Oberseiten der Schichten der zweiten Halbleiterbauelemente mehrerer der Chips verbunden ist. Jede temporäre Leiterbahn kontaktiert also sowohl erste als auch zweite Halbleiterbauelemente. Eine temporäre Leiterbahn kann z. B. Unterseiten von ersten und Unterseiten von zweiten Halbleiterbauelementen, oder Unterseiten von ersten und Oberseiten von zweiten Halbleiterbauelementen, oder Oberseiten von ersten und Unterseiten von zweiten Halbleiterbauelementen, oder Oberseiten von ersten und Oberseiten von zweiten Halbleiterbauelementen kontaktieren.

Für eine übersichtliche Anordnung der temporären Leiterbahnen ist es vorteilhaft, die Chips so zu erzeugen, daß sie in Felder, die in Reihen und Spalten auf dem Wafer angeordnet sind, gruppiert sind. Für jede Spalte der Felder können dann zwei der temporären Leiterbahnen erzeugt werden, die sich innerhalb der Felder zu den einzelnen Chips hin verästeln.

Es liegt im Rahmen der Erfindung, pro Chip weitere Halbleiterbauelemente zu erzeugen. Die weiteren Halbleiterbauelemente können beispielsweise Transistoren oder Kondensatoren oder ähnlich wie die ersten Halbleiterbauelemente aufgebaut sein.

Der Chip kann beispielsweise so hergestellt werden, daß er einen Bulk-Acoustic-Wave-Filter umfaßt.

Das Anlegen der Spannungen an die temporären Leiterbahnen findet vorzugsweise bei erhöhter Temperatur, z.B. bei über 150°C, statt.

Im folgenden werden Ausführungsbeispiele der Erfindung anhand der Figuren näher erläutert.
- Figur 1: zeigt eine Aufsicht auf einen Wafer mit zu Feldern gruppierten Chips.
- Figur 2: zeigt einen Ausschnitt eines Querschnitts durch den Wafer mit einem ersten Halbleiterbauelement eines Chips, nachdem eine isolierende Schicht, eine untere Elektrode, eine Schicht, eine obere Elektrode und eine Zwischenschicht erzeugt wurden.
- Figur 3: zeigt den Ausschnitt aus Figur 2, nachdem eine Diffusionsbarrierenschicht und Kontakte erzeugt wurden.
- Figur 4a: zeigt die Aufsicht auf den Wafer aus Figur 1, nach-dem temporäre Leiterbahnen erzeugt wurden und eine Spannungsquelle angeschlossen wurde.
- Figur 4b: zeigt einen Ausschnitt der Aufsicht aus Figur 4a mit den Chips eines Feldes.
- Figur 4c: zeigt das Schaltbild eines Chips mit den temporären Leiterbahnen.
- Figur 5a: zeigt den Querschnitt aus Figur 3, nachdem die temporären Leiterbahnen abschnittsweise entfernt wurden und Leiterbahnen einer Metallisierung erzeugt wurden.
- Figur 5b: zeigt das Schaltbild eines Chips mit den Leiterbahnen der Metallisierung.
- Figur 6a: zeigt einen Ausschnitt eines Querschnitts durch einen zweiten Wafer mit einem ersten Halbleiterbauelement, nachdem eine isolierende Schicht, eine untere Elektrode, eine Schicht, eine obere Elektrode, eine Zwischenschicht, eine Diffusionsbarrierenschicht, Kontakte und temporäre Leiterbahnen erzeugt wurden.
- Figur 6b: zeigt den Ausschnitt aus Figur 6a, nachdem die temporären Leiterbahnen abschnittsweise entfernt wurden und Leiterbahnen einer Metallisierung erzeugt wurden.

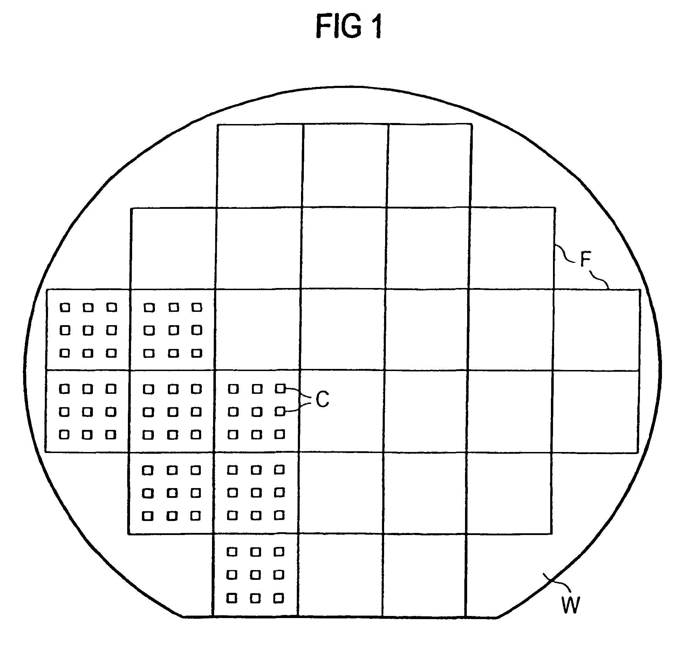

In einem ersten Ausführungsbeispiel wird als Ausgangsmaterial ein Wafer W aus Silizium verwendet. Auf dem Wafer W werden Chips C erzeugt. Jeweils neun Chips C sind zu einem Feld F gruppiert. Die Felder F sind in Reihen und Spalten auf dem Wafer W angeordnet (siehe Figur 1). Die Chips C sind analog zueinander aufgebaut. Der Einfachheit halber sind in Figur 1 nicht alle Chips C dargestellt.

Für jeden Chip C werden sechs analog zueinander aufgebaute Halbleiterbauelemente erzeugt. Das Herstellungsverfahren wird anhand eines ersten Halbleiterbauelements erläutert.

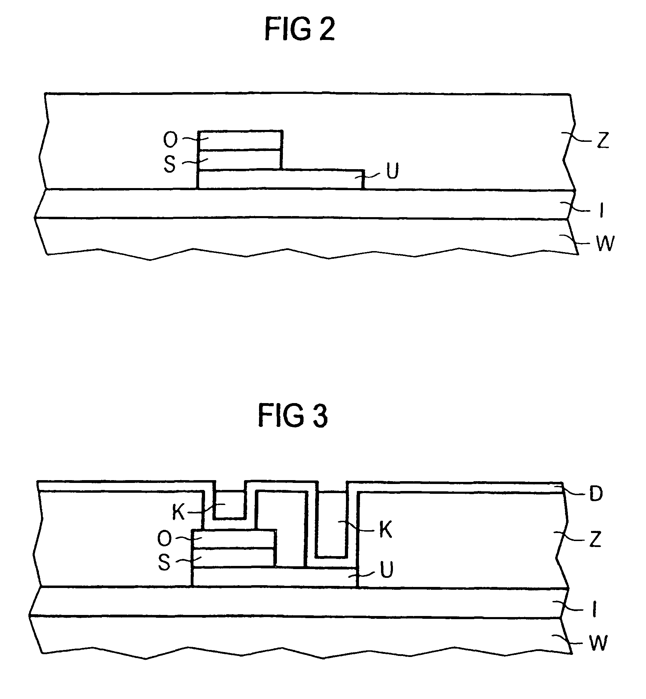

Auf dem Wafer W wird eine ca. 500 nm dicke isolierende Schicht I aus SiO₂ erzeugt (siehe Figur 2). Darüber wird Platin in einer Dicke von ca. 100 nm abgeschieden und strukturiert, um eine untere Elektrode U zu bilden.

Über der unteren Elektrode U wird PZT in einer Dicke von ca. 1500 nm und darüber Platin in einer Dicke von ca. 100 nm abgeschieden. Das Platin und das PZT werden durch Ätzen strukturiert, um eine piezoelektrische Schicht S und darüber eine obere Elektrode O zu bilden. Das erste Halbleiterbauelement umfaßt die untere Elektrode U, die Schicht S und die obere Elektrode O. Die Schicht S weist zu diesem Zeitpunkt eine geringe elektrische Polarisation auf. Das Entsprechende gilt für die übrigen fünf Halbleiterbauelemente des Chips C. Die Halbleiterbauelemente sind als Bulk-Acoustic-Wave Resonator ausgestaltet.

Zur Erzeugung einer Zwischenschicht Z wird SiO₂ in einer Dikke von ca. 1µm abgeschieden und planarisiert. Durch maskiertes Ätzen werden Kontaktlöcher geöffnet, die bis zu den oberen Elektroden O und den unteren Elektroden U reichen.

Anschließend wird eine ca. 30 nm dicke Teilschicht aus Titan und darüber eine ca. 30 nm dicke Teilschicht aus TiN erzeugt. Die beiden Teilschichten bilden zusammen eine Diffusionsbarrierenschicht D (siehe Figur 3). Die Diffusionsbarrierenschicht D ist so dünn, daß sie die Kontaktlöcher nicht auffüllt.

Zur Erzeugung von Kontakten K wird Wolfram in einer Dicke von ca. 800 nm abgeschieden und rückgeätzt, bis Teile der Diffusionsbarrierenschicht D freigelegt werden (siehe Figur 3).

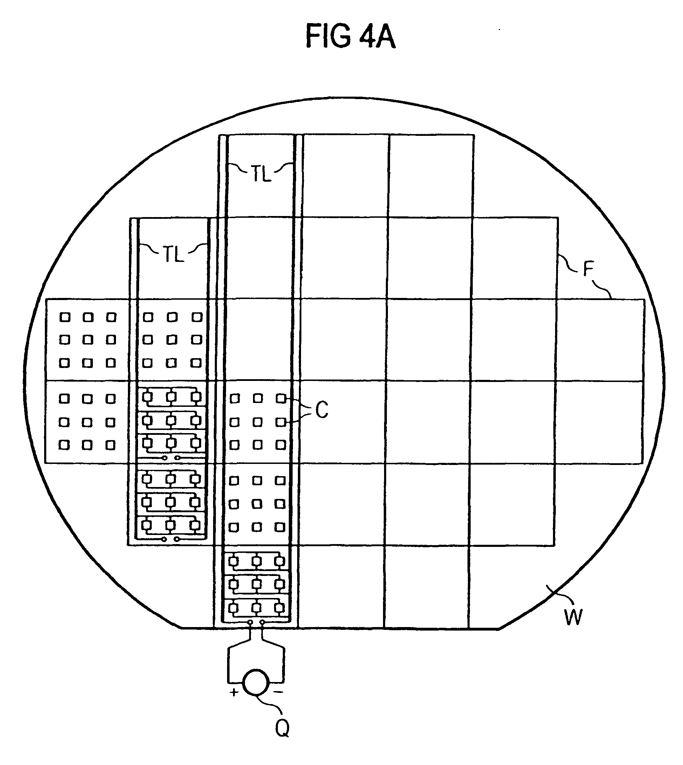

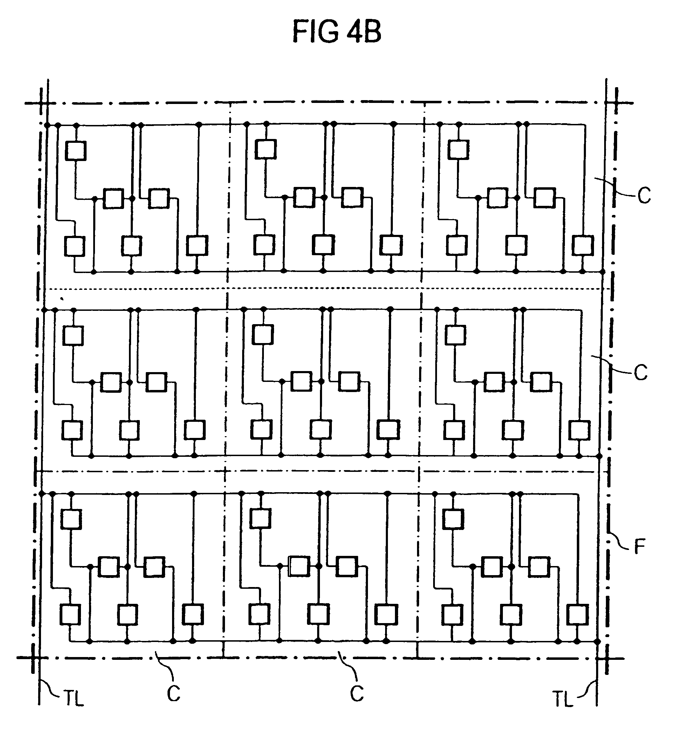

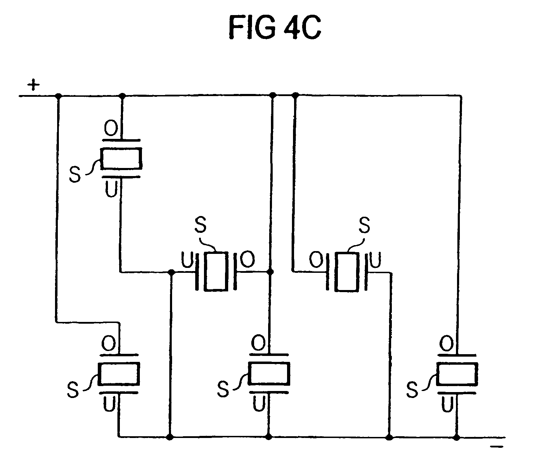

Mit Hilfe einer Maske aus Fotolack wird die Diffusionsbarrierenschicht D zu temporären Leiterbahnen TL strukturiert. Für jede Spalte von Feldern F werden zwei temporäre Leiterbahnen TL erzeugt (siehe Figur 4a). Die temporären Leiterbahnen TL verästeln sich in den Feldern F zu den einzelnen Chips C hin (siehe Figuren 4a und 4b). Der Einfachheit halber sind in Figuren 4a und 4b nicht alle temporären Leiterbahnen TL und deren Verästelungen dargestellt. Die temporären Leiterbahnen TL sind mit oberen Elektroden O oder mit unteren Elektroden U der Halbleiterbauelemente verbunden. Jedes Halbleiterbauelement ist zwischen zwei der temporären Leiterbahnen TL geschaltet. Figur 4c zeigt das Schaltbild eines Chips C mit seinen sechs Halbleiterbauelementen, die mit den temporären Leiterbahnen TL verbunden sind.

Zur Polarisierung der Schichten S der Halbleiterbauelemente werden an die zwei temporären Leiterbahnen TL jeder Spalte von Feldern F mittels einer Spannungsquelle Q Spannungen angelegt und dadurch in den Schichten S ein Spannungsabfall erzeugt. In Figur 4a sind die zwei temporären Leiterbahnen TL der dritten Spalte der Felder mit der Spannungsquelle Q verbunden, so daß die Schichten S der Chips C der dritten Spalte der Felder F polarisiert werden.

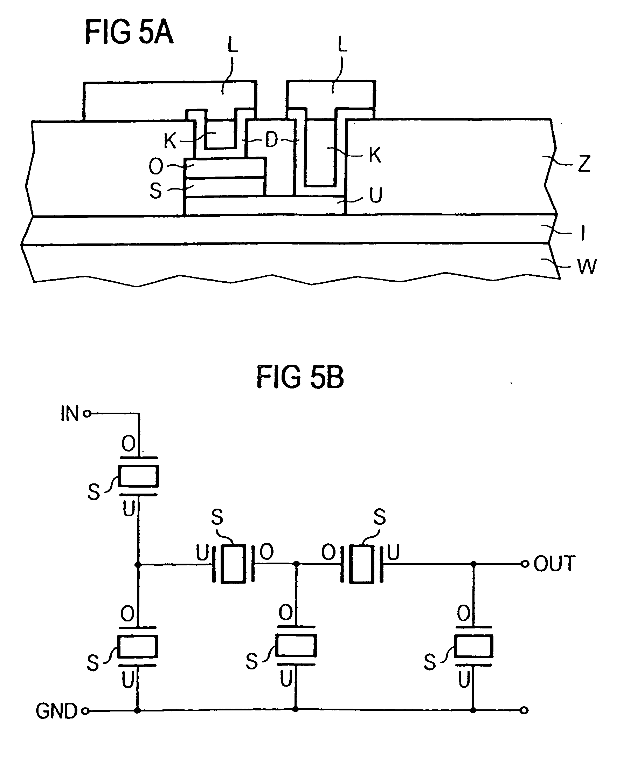

Nach der Polarisierung der Schichten S wird AlSiCu in einer Dicke von ca. 1µm abgeschieden und durch maskiertes Ätzen zu Leiterbahnen L einer Metallisierung der Chips C strukturiert (siehe Figuren 5a und 5b). Bei der Strukturierung wird auch Titan und TiN entfernt, so daß die temporären Leiterbahnen TL abschnittsweise entfernt werden.

Durch die Leiterbahnen L der Metallisierung werden die Halbleiterbauelemente der Chips C derart verdrahtet, daß jeder Chip C einen Bulk-Acoustic-Wave-Filter bildet (siehe Figur 5b).

Anschließend werden die Chips C vereinzelt, das heißt, der Wafer W wird zersägt, so daß die Chips C voneinander getrennt werden.

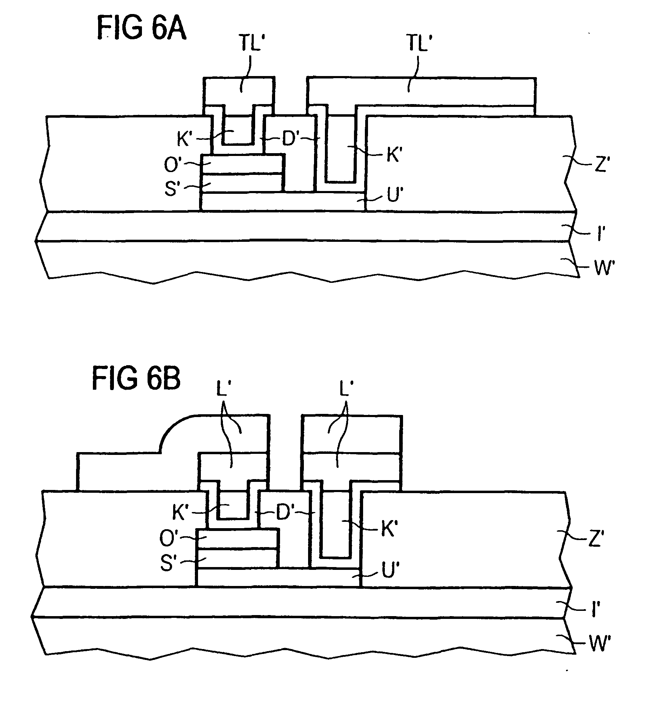

In einem zweiten Ausführungsbeispiel wird analog wie im ersten Ausführungsbeispiel ein Wafer mit Chips in Feldern erzeugt, wobei jeder Chip sechs Halbleiterbauelemente aufweist. Wie im ersten Ausführungsbeispiel werden eine isolierende Schicht I', eine untere Elektrode U', eine Schicht S', eine obere Elektrode O', eine Zwischenschicht Z', eine Diffusionsbarrierenschicht D' und Kontakte K' erzeugt (siehe Figur 6a).

Zur Erzeugung von temporären Leiterbahnen TL' wird AlSiCu in einer Dicke von ca. 800 nm abgeschieden und mit Hilfe einer Maske aus Fotolack strukturiert. Die temporären Leiterbahnen TL' verlaufen genauso wie im ersten Ausführungsbeispiel.

Nach Polarisierung der Schichten S' wird AlSiCu in einer Dikke von ca. 800 nm abgeschieden und mit Hilfe einer weiteren Maske aus Fotolack geätzt, bis die Zwischenschicht Z' freigelegt wird. Dadurch werden Leiterbahnen L' einer Metallisierung der Chips erzeugt, deren erste Teile aus übrigbleibenden Teil der temporären Leiterbahnen TL' bestehen und deren zweite Teile aus dem zuletzt abgeschiedenen AlSiCu bestehen (siehe Figur 6b). Die Leiterbahnen L' der Metallisierung sind also in einigen Bereichen dicker als in anderen. Die Leiterbahnen L' der Metallisierung verlaufen wie die Leiterbahnen L der Metallisierung aus dem ersten Ausführungsbeispiel.

In einem dritten Ausführungsbeispiel werden wie im ersten Ausführungsbeispiel ein Wafer mit Chips in Feldern erzeugt. Wie im ersten Ausführungsbeispiel umfaßt jeder Chip sechs Halbleiterbauelemente. Bis zur Erzeugung der Kontakte ist das Herstellungsverfahren identisch mit dem Herstellungsverfahren des ersten Ausführungsbeispiels.

Zur Erzeugung von temporären Leiterbahnen wird amorphes Silizium in einer Dicke von ca. 50 nm abgeschieden und zusammen mit der Diffusionsbarrierenschicht strukturiert. Der Verlauf der temporären Leiterbahnen entspricht dem Verlauf der temporären Leiterbahnen TL des ersten Ausführungsbeispiels.

Nach Polarisierung der Schichten der Halbleiterbauelemente werden die temporären Leiterbahnen vollständig durch Trokkenätzen mit z. B. CF₄ entfernt.

Zur Erzeugung von Leiterbahnen einer Metallisierung der Chips wird AlSiCu in einer Dicke von ca. 800 nm abgeschieden und mit Hilfe einer Maske aus Fotolack strukturiert. Die Leiterbahnen der Metallisierung verlaufen wie die Leiterbahnen L der Metallisierung des ersten Ausführungsbeispiels.

### Bezugszeichenliste

- c: Chip
- D, D': Diffusionsbarrierenschicht
- F: Feld
- I, I': isolierende Schicht
- K, K': Kontakt
- L, L': Leiterbahn einer Metallisierung
- O, O': Obere Elektrode
- S, S': Schicht
- TL, TL': temporäre Leiterbahn
- U, U': Untere Elektrode
- W: Wafer
- Z, Z': Zwischenschicht

## Patentansprüche

1. Verfahren zur Erzeugung analog zueinander aufgebauter Chips, die jeweils ein erstes Halbleiterbauelement, das eine Schicht mit einer definierten elektrischen Polarisation aufweist, aufweisen,
- bei dem die Chips (C) auf einem Wafer (W) erzeugt werden,
- bei dem die Schichten (S) der ersten Halbleiterbauelemente so erzeugt werden daß sie zunächst nicht ihre volle Polarisation aufweisen,
- bei dem pro Chip (C) mindestens ein zweites Halbleiterbauelement erzeugt wird,
- bei dem zur Erzeugung temporärer Leiterbahnen (TL) leitendes Material abgeschieden und derart strukturiert wird, daß jede Schicht (S) der ersten Halbleiterbauelemente zwischen zwei der temporären Leiterbahnen (TL) geschaltet ist, und daß jede temporäre Leiterbahn (TL) mit Unterseiten oder Oberseiten der Schichten (S) der ersten Halbleiterbauelemente mehrerer der Chips (C) verbunden ist,
- bei dem die Schichten (S) der ersten Halbleiterbauelemente gepolt werden, indem Spannungen an die temporären Leiterbahnen (TL) angelegt werden,
- bei dem die temporären Leiterbahnen (TL) nach Polarisierung der Schichten (S) der ersten Halbleiterbauelemente zumindest abschnittsweise entfernt werden,
- bei dem zum Verschalten der ersten Halbleiterbauelemente mit den zweiten Halbleiterbauelementen Leiterbahnen (L) einer Metallisierung der Chips (C) erzeugt werden, und
- bei dem die Chips (C) nach deren Fertigstellung vereinzelt werden.

2. Verfahren nach Anspruch 1,
- bei dem die Schichten (S) der ersten Halbleiterbauelemente aus einem piezo- oder pyroelektrischen Material erzeugt werden.

3. Verfahren nach Anspruch 2,
- bei dem das erste Halbleiterbauelement als Bulk-Acoustic-Wave-Resonator erzeugt wird.

4. Verfahren nach einem der Ansprüche 1 bis 3,
- bei dem pro erstem Halbleiterbauelement eine untere Elektrode (U), darüber die Schicht (S), die zunächst nicht ihre volle Polarisation aufweist, und darüber eine obere Elektrode (O) erzeugt werden, und
- bei dem zur Erzeugung der temporären Leiterbahnen (TL) leitendes Material abgeschieden und derart strukturiert wird, daß jede temporäre Leiterbahn mit (TL) unteren (U) oder oberen Elektroden (O) der ersten Halbleiterbauelemente mehrerer der Chips (C) verbunden ist.

5. Verfahren nach Anspruch 4,
- bei dem über den ersten Halbleiterbauelementen und den zweiten Halbleiterbauelementen eine isolierende Zwischenschicht (Z) abgeschieden wird,
- bei dem Kontaktlöcher in der Zwischenschicht (Z) zu den ersten Halbleiterbauelementen und den zweiten Halbleiterbauelementen erzeugt werden,
- bei dem eine Diffusionsbarrierenschicht (D) aus leitendem Material mit einer solchen Dicke abgeschieden wird, daß sie die Kontaktlöcher nicht ausfüllt,
- bei dem zur Erzeugung von Kontakten (K) leitendes Material in einer solchen Dicke abgeschieden wird, daß die Kontaktlöcher ausgefüllt werden, und soweit rückgeätzt wird, daß die Diffusionsbarrierenschicht (D) freigelegt wird,
- bei dem durch Strukturierung der Diffusionsbarrierenschicht (D) die temporären Leiterbahnen (TL) erzeugt werden, und
- bei dem nach Polarisierung der Schichten (S) der ersten Halbleiterbauelemente zur Erzeugung der Leiterbahnen (L) der Metallisierung leitendes Material abgeschieden und strukturiert wird, wobei außerhalb der Leiterbahnen (L) der Metallisierung liegende Teile der Diffusionsbarrierenschicht (D) entfernt werden.

6. Verfahren nach einem der Ansprüche 1 bis 4,
- bei dem die temporären Leiterbahnen nach Polarisierung der Schichten der ersten Halbleiterbauelemente vollständig durch unmaskiertes selektives Ätzen entfernt werden.

7. Verfahren nach Anspruch 6,
- bei dem die temporären Leiterbahnen aus amorphem Silizium erzeugt werden.

8. Verfahren nach einem der Ansprüche 1 bis 4,
- bei dem die temporären Leiterbahnen (TL') nach Polarisierung der Schichten (S') abschnittsweise derart entfernt werden, daß übrigbleibende Teile der temporären Leiterbahnen (TL') erste Teile der Leiterbahnen (L') der Metallisierung bilden, und
- bei dem zur Erzeugung zweiter Teile der Leiterbahnen (L') der Metallisierung leitendes Material abgeschieden und strukturiert wird.

9. Verfahren nach Anspruch 8,
- bei dem die temporären Leiterbahnen (TL') und die Leiterbahnen (L') der Metallisierung aus demselben leitenden Material erzeugt werden, und
- bei dem zur Erzeugung der zweiten Teile der Leiterbahnen (L') der Metallisierung das leitende Material derart strukturiert wird, daß die ersten Teile der Leiterbahnen (L') der Metallisierung unter Teilen der zweiten Teile der Leiterbahnen (L') der Metallisierung liegen.

10. Verfahren nach einem der Ansprüche 1 bis 9,
- bei dem für die zweiten Halbleiterbauelemente jeweils eine Schicht (S) mit einer definierten elektrischen Polarisation erzeugt wird, und
- bei dem die temporären Leiterbahnen (TL) so erzeugt werden, daß jede Schicht (S) der zweiten Halbleiterbauelemente zwischen zwei der temporären Leiterbahnen (TL) geschaltet ist, und daß jede temporäre Leiterbahn (TL) mit Unterseiten oder Oberseiten der Schichten (S) der zweiten Halbleiterbauelemente mehrerer der Chips (C) verbunden ist.

11. Verfahren nach einem der Ansprüche 1 bis 10,
- bei dem die Chips (C) so erzeugt werden, daß sie in Felder (F), die in Reihen und Spalten auf dem Wafer (W) angeordnet sind, gruppiert sind, und
- bei dem für jede Spalte der Felder (F) zwei der temporären Leiterbahnen (TL) erzeugt werden, die sich innerhalb der Felder zu den einzelnen Chips (C) hin verästeln.

12. Verfahren nach einem der Ansprüche 1 bis 11,
- bei dem pro Chip (C) weitere Halbleiterbauelemente erzeugt werden.

## Revendications

1. Procédé de production de puces constituées d'une manière semblable les unes aux autres qui ont, respectivement, un premier composant à semi-conducteurs, lequel a une couche de polarisation électrique définie,
- dans lequel on produit les puces (C) sur une tranche (W) ;
- dans lequel on produit les couches (S) des premiers composants à semi-conducteurs, de façon à ce qu'elles n'aient pas d'abord toute leur polarisation ;
- dans lequel on produit par puce (C) au moins un deuxième composant à semi-conducteurs ;
- dans lequel, pour produire des pistes (TL) conductrices temporaires, on dépose du matériau conducteur et on le structure de façon à ce que chaque couche (S) des premiers composants à semi-conducteurs soit montée électriquement entre deux des pistes (TL) conductrices temporaires et en ce que chaque piste (TL) conductrice temporaire soit reliée à des faces inférieures ou à des faces supérieures des couches (S) des premiers composants à semi-conducteurs de plusieurs des puces (C) ;
- dans lequel on polarise les couches (S) des premiers composants à semi-conducteurs en appliquant des tensions aux pistes (TL) conductrices temporaires ;
- dans lequel on élimine au moins par tronçon les pistes (TL) conductrices temporaires après polarisation des couches (S) des premiers composants à semi-conducteurs ;
- dans lequel, pour relier les premiers composants à semi-conducteurs aux deuxièmes composants à semi-conducteurs, on produit des pistes (L) conductrices d'une métallisation des puces (C) ; et
- dans lequel on individualise les puces (C) après leur finition.

2. Procédé suivant la revendication 1,
- dans lequel on produit les couches (S) des premiers composants à semi-conducteurs en un matériau piézoélectrique ou pyroélectrique.

3. Procédé suivant la revendication 2,
- dans lequel on produit le premier composant à semi-conducteurs sous la forme d'un résonateur bulk-acoustic-wave.

4. Procédé suivant l'une des revendications 1 à 3,
- dans lequel on produit par premier composant à semi-conducteurs une électrode (U) inférieure, au-dessus la couche (S) qui n'a pas d'abord toute sa polarisation, et au-dessus une électrode (O) supérieure ; et
- dans lequel, pour produire les pistes (TL) conductrices temporaires, on dépose du matériau conducteur et on le structure de façon à ce que chaque piste (TL) conductrice temporaire soit reliée à des électrodes inférieures (U) ou supérieures (0) des premiers composants à semi-conducteurs de plusieurs des puces (C).

5. Procédé suivant la revendication 4,
- dans lequel on dépose sur les premiers composants à semi-conducteurs et sur les deuxièmes composants à semi-conducteurs une couche (Z) intermédiaire isolante ;
- dans lequel on produit des trous de contact dans la couche (Z) intermédiaire allant aux premiers composants à semi-conducteurs et aux deuxièmes composants à semi-conducteurs ;
- dans lequel on dépose une couche (D) formant barrière de diffusion en un matériau conducteur en une épaisseur telle qu'elle ne remplit pas les trous de contact ;
- dans lequel, pour la production de contacts (K), on dépose du matériau conducteur en une épaisseur telle que les trous de contact sont remplis et on attaque latéralement jusqu'à ce que la couche (D) formant barrière de diffusion soit mise à nu ;
- dans lequel on produit les pistes (TL) conductrices temporaires par structuration de la couche (D) formant barrière de diffusion ; et
- dans lequel, après polarisation des couches (S) des premiers composants à semi-conducteurs, on dépose et on structure, pour produire les pistes (L) conductrices de la métallisation, du matériau conducteur et on élimine des parties de la couche (D) formant barrière de diffusion qui se trouvent à l'extérieur des pistes (L) conductrices de la métallisation.

6. Procédé suivant l'une des revendications 1 à 4,
- dans lequel on élimine complètement par attaque sélective non masquée les pistes conductrices temporaires après polarisation des couches des premiers composants à semi-conducteurs.

7. Procédé suivant la revendication 6,
- dans lequel on produit les pistes conductrices temporaires en silicium amorphe.

8. Procédé suivant l'une des revendications 1 à 4,
- dans lequel on élimine les pistes (TL') conductrices temporaires après polarisation des couches (S') par tronçon, de façon à ce que des parties restantes des pistes (TL') conductrices temporaires forment des premières parties des pistes (L') conductrices de la métallisation ; et
- dans lequel on dépose et on structure du matériau conducteur pour la production de deuxièmes parties des pistes (L') conductrices de la métallisation.

9. Procédé suivant la revendication 8,
- dans lequel on produit les pistes (TL') conductrices temporaires et les pistes (L') conductrices de la métallisation en le même matériau conducteur ; et
- dans lequel, pour produire les deuxièmes parties des pistes (L') conductrices de la métallisation, on structure le matériau conducteur, de façon à ce que les premières parties des pistes (L') conductrices de la métallisation se trouvent sous des parties des deuxièmes parties des pistes (L') conductrices de la métallisation.

10. Procédé suivant l'une des revendications 1 à 9,
- dans lequel on produit pour les deuxièmes composants à semi-conducteurs, respectivement, une couche (S) de polarisation électrique définie ; et
- dans lequel on produit les pistes (TL) conductrices temporaires, de façon à ce que chaque couche (S) des deuxièmes composants à semi-conducteurs soit montée électriquement entre deux des pistes (TL) conductrices temporaires et en ce que chaque piste (TL) conductrice temporaire soit reliée à des faces inférieures ou à des faces supérieures des couches (S) des deuxièmes composants à semi-conducteurs de plusieurs des puces (C).

11. Procédé suivant l'une des revendications 1 à 10,
- dans lequel on produit les puces (C), de façon à ce qu'elles soient regroupées dans des champs (F) qui sont disposés en lignes et en colonnes sur la tranche (W) ; et
- dans lequel on produit pour chaque colonne des champs (F) deux pistes (TL) conductrices temporaires qui se ramifient à l'intérieur des champs en les diverses puces (C).

12. Procédé suivant l'une des revendications 1 à 11,
- dans lequel on produit par puce (C) des composants à semi-conducteurs supplémentaires.

## Claims

1. Method for producing chips which are constructed analogously to one another and in each case have a first semiconductor component having a layer with a defined electrical polarization,
- in which the chips (C) are produced on a wafer (W),
- in which the layers (S) of the first semiconductor components are produced in such a way that they initially do not have their full polarization,
- in which at least one second semiconductor component is produced per chip (C),
- in which, in order to produce temporary interconnects (TL), conductive material is deposited and patterned in such a way that each layer (S) of the first semiconductor components is connected between two of the temporary interconnects (TL), and that each temporary interconnect (TL) is connected to undersides or top sides of the layers (S) of the first semiconductor components of a plurality of the chips (C),
- in which the layers (S) of the first semiconductor components are polarized by voltages being applied to the temporary interconnects (TL),
- in which the temporary interconnects (TL) are removed at least in sections after the layers (S) of the first semiconductor components have been polarized,
- in which interconnects (L) of a metallization of the chips (C) are produced for the purpose of connecting the first semiconductor components to the second semiconductor components, and
- in which the chips (C) are singulated after their completion.

2. Method according to Claim 1,
- in which the layers (S) of the first semiconductor components are produced from a piezoelectric or pyroelectric material.

3. Method according to Claim 2,
- in which the first semiconductor component is produced as a bulk acoustic wave resonator.

4. Method according to one of Claims 1 to 3,
- in which a bottom electrode (U), above the latter the layer (S), which initially does not have its full polarization, and above the latter a top electrode (O) are produced per first semiconductor component, and
- in which, in order to produce the temporary interconnects (TL), conductive material is deposited and patterned in such a way that each temporary interconnect (TL) is connected to bottom (U) or top electrodes (0) of the first semiconductor components of a plurality of the chips (C).

5. Method according to Claim 4,
- in which an insulating intermediate layer (Z) is deposited above the first semiconductor components and the second semiconductor components, and
- in which contact holes are produced in the intermediate layer (Z) to the first semiconductor components and the second semiconductor components,
- in which a diffusion barrier layer (D) made of conductive material is deposited with a thickness such that it does not fill the contact holes,
- in which, in order to produce contacts (K), conductive material is deposited with a thickness such that the contact holes are filled, and is etched back to an extent such that the diffusion barrier layer (D) is uncovered,
- in which the temporary interconnects (TL) are produced by patterning the diffusion barrier layer (D), and
- in which, after the layers (S) of the first semiconductor components have been polarized, in order to produce the interconnects (L) of the metallization, conductive material is deposited and patterned, parts of the diffusion barrier layer (D) which lie outside the interconnects (L) of the metallization being removed.

6. Method according to one of Claims 1 to 4,
- in which the temporary interconnects are completely removed by unmasked selective etching after the layers of the first semiconductor components have been polarized.

7. Method according to Claim 6,
- in which the temporary interconnects are produced from amorphous silicon.

8. Method according to one of Claims 1 to 4,
- in which the temporary interconnects (TL') are removed in sections after the layers (S') have been polarized in such a way that remaining parts of the temporary interconnects (TL') form first parts of the interconnects (L') of the metallization, and
- in which, in order to produce second parts of the interconnects (L') of the metallization, conductive material is deposited and patterned.

9. Method according to Claim 8,
- in which the temporary interconnects (TL') and the interconnects (L') of the metallization are produced from the same conductive material, and
- in which in order to produce the second parts of the interconnects (L') of the metallization, the conductive material is patterned in such a way that the first parts of the interconnects (L') of the metallization lie below parts of the second parts of the interconnects (L') of the metallization.

10. Method according to one of Claims 1 to 9,
- in which a layer (S) with a defined electrical polarization is in each case produced for the second semiconductor components, and
- in which the temporary interconnects (TL) are produced in such a way that each layer (S) of the second semiconductor components is connected between two of the temporary interconnects (TL), and that each temporary interconnect (TL) is connected to undersides or top sides of the layers (S) of the second semiconductor components of a plurality of the chips (C).

11. Method according to one of Claims 1 to 10,
- in which the chips (C) are produced in such a way that they are grouped in arrays (F) arranged in rows and columns on the wafer (W), and
- in which two of the temporary interconnects (TL) are produced for each column of the arrays (F), the said interconnects being ramified within the arrays towards the individual chips (C).

12. Method according to one of Claims 1 to 11,
- in which further semiconductor components are produced per chip (C).
